# EUROPEAN PATENT APPLICATION

(11) **EP 2 978 281 A1**
(43) Date of publication of application: **27.01.2016**
(21) Application number: 14768137.3
(22) Date of filing: 11.03.2014
(51) Int. Cl.: H05B 33/10, H01L 51/50, H05B 33/02, H05B 33/04

(54) **METHOD FOR MANUFACTURING ORGANIC ELECTROLUMINESCENT DEVICES**

(30) Priority: 22.03.2013 JP 2013059613
(71) Applicant: Nitto Denko Corporation, Ibaraki-shi, Osaka 567-8680 (JP)
(72) Inventor: OSAKI Yoshinori, Ibaraki-shi Osaka 567-8680 (JP)
(74) Representative: Grünecker Patent- und Rechtsanwälte PartG mbB
(86) International application number: PCT/JP2014/056362
(87) International publication number: WO 2014/148320

(57) **Abstract**

A method for producing an organic electroluminescence device of the present invention includes a laminating step of laminating a belt-shaped sealing substrate 5 on a belt-shaped supporting substrate 2 on which a plurality of organic EL elements 3 are formed while interposing an uncured thermosetting type adhesive layer 52, a winding step of winding a belt-shaped laminated body 11 having the belt-shaped supporting substrate 2, the organic EL elements 3 and the sealing substrate 5 into a roll, and a curing step of applying heat to the laminated body 11 to perform curing of the adhesive layer 52 while the laminated body 11 remains wound into a roll.

## Description

### TECHNICAL FIELD

The present invention relates to a method for producing organic electroluminescence device.

### BACKGROUND ART

Hereinafter, the organic electroluminescence is referred to as "organic EL".

An organic EL device having a supporting substrate, an organic EL element provided on the supporting substrate, and a sealing substrate provided on the organic EL element has hitherto been known. The organic EL element has a first electrode, a second electrode, and an organic layer provided between the both electrodes.

As a method for manufacturing the organic EL device, a roll-to-roll method has been known.

A roll-to-roll method is a production method in which a desired layer is formed on a flexible substrate while the substrate wound into a roll is transported intermittently or continuously, and the substrate is wound into a roll again.

The production method of an organic EL device using a roll-to-roll method includes the step of feeding out a belt-shaped supporting substrate wound into a roll, the step of forming a plurality of organic EL elements on the belt-shaped supporting substrate, the step of laminating a belt-shaped sealing substrate having an uncured adhesive layer provided thereon on the plurality of organic EL elements via the adhesive layer, the step of fixing the sealing substrate to the organic EL element by heating the sealing substrate and curing the adhesive layer, the winding step of winding a belt-shaped laminated body having the belt-shaped supporting substrate, the organic EL elements and the sealing substrate into a roll, and the step of feeding out the belt-shaped laminated body to be cut at required portions and taking out individual organic EL devices (Patent Document 1).

Although the curing step for the adhesive layer is performed while the laminated body is transported, in order to perform thermal curing of the adhesive layer, the laminated body is required to be heated for a relatively long period of time. Consequently, a large heating device is required and the production device becomes larger in size. That is, the more the transport speed of the laminated body is increased for enhancing the productivity, the larger heating device needs to be used, and it is difficult to achieve both the enhancement in productivity and the reduction in size of the heating device.

Moreover, the sealing substrate is provided for preventing moisture and the like from entering the organic EL element. When the organic EL device is curved, there is a problem that the organic EL element is damaged or the sealing substrate peels off and the durability of the organic EL device is lowered.

[Patent Document 1] JP 2010-097803 A

### SUMMARY OF THE INVENTION

A first object of the present invention is to provide a method capable of producing an organic EL device, which is relatively high in productivity, by using a small-size heating device and curing an adhesive layer.

A second object of the present invention is to provide a method capable of producing an organic EL device excellent in durability.

A first method for producing an organic EL device of the present invention includes a laminating step of laminating a belt-shaped sealing substrate on a belt-shaped supporting substrate on which a plurality of organic EL elements are formed while interposing an uncured thermosetting type adhesive layer, a winding step of winding a belt-shaped laminated body having the belt-shaped supporting substrate, the organic EL elements and the sealing substrate into a roll, and a curing step of applying heat to the laminated body to perform curing of the adhesive layer while the laminated body remains wound into a roll.

In a preferable method for producing an organic EL device of the present invention, either one substrate of the supporting substrate and the sealing substrate has a coefficient of linear thermal expansion larger than that of the other substrate, and in the winding step, the laminated body is wound into a roll so that the one substrate having a larger coefficient of linear thermal expansion faces outward.

In another preferable method for producing an organic EL device of the present invention, the laminated body is wound into a roll with a diameter greater than or equal to 100 mm.

In another preferable method for producing an organic EL device of the present invention, the one substrate having a larger coefficient of linear thermal expansion is the sealing substrate, and the supporting substrate has a coefficient of linear thermal expansion smaller than that of the sealing substrate.

In another preferable method for producing an organic EL device of the present invention, the one substrate having a larger coefficient of linear thermal expansion is the supporting substrate, and the sealing substrate has a coefficient of linear thermal expansion smaller than that of the supporting substrate.

According to the production method of the present invention, it is possible to obtain an organic EL device, which is relatively high in productivity, by using a small-size heating device and allowing an adhesive layer to be cured. Consequently, it is possible to produce an organic EL device at low costs with a relatively small production device.

Moreover, according to the production method of the present invention, it is possible to obtain an organic EL device which is hardly curved and is substantially flat. In the organic EL device, the sealing substrate hardly partially peels off from the organic EL element, and moreover, the organic EL element is hardly damaged. Consequently, according to the production method of the present invention, it is possible to provide an organic EL device excellent in durability.

### BRIEF DESCRIPTION OF THE DRAWINGS

Fig. 1 is a plan view of an organic EL device according to one embodiment of the present invention.
Fig. 2 is an enlarged sectional view taken along the line II-II in Fig. 1.
Fig. 3 is an enlarged sectional view taken in the thickness direction of an organic EL device according to another embodiment of the present invention.
Fig. 4 is a plan view of a sheet-like organic EL device.
Fig. 5 is a schematic view of an apparatus used in the production method according to one embodiment of the present invention.
Fig. 6 is an enlarged sectional view of a belt-shaped sealing substrate which is temporarily stacked on a separator.
Fig. 7 is a partially omitted reference sectional view of a laminated body wound into a roll (a wound body) used in the production method according to one embodiment of the present invention.
Fig. 8 is a partially omitted reference sectional view of a laminated body wound into a roll (a wound body) used in the production method according to another embodiment of the present invention.

### DESCRIPTION OF THE EMBODIMENTS

Hereinafter, the present invention will be described with reference to the drawings. It should be noted that dimensions such as a thickness and a length in the drawings are different from actual dimensions.

In this specification, the terms "first" and "second" may be added as prefixes. These prefixes, however, are only added in order to distinguish the terms and do not have specific meaning such as order and relative merits. The "belt-shaped" means a substantially rectangular shape in which a length in one direction is sufficiently larger than a length in the other direction. The "belt-shaped" is a substantially rectangular shape in which a length in one direction is greater than or equal to 10 times, preferably greater than or equal to 30 times, more preferably greater than or equal to 100 times of a length in the other direction. The "long-side direction" is one direction of the belt shape (direction parallel to the longer side of the belt shape), and the "short-side direction" is the other direction of the belt shape (direction parallel to the shorter side of the belt shape). The wording "PPP to QQQ" indicates "greater than or equal to PPP and less than or equal to QQQ".

### [Configuration of Organic EL Device]

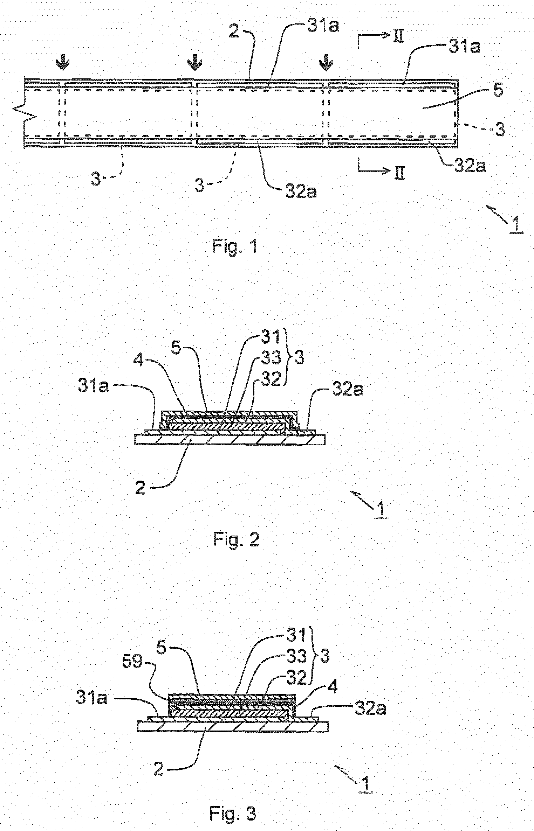

As illustrated in Fig. 1 and Fig. 2, an organic EL device 1 of the present invention has a belt-shaped supporting substrate 2, an organic EL element 3 provided on the belt-shaped supporting substrate 2, and a belt-shaped sealing substrate 5 stuck on the organic EL element 3 via an adhesive layer 4. A plurality of the organic EL elements 3 is arranged at required intervals in the long-side direction of the belt-shaped supporting substrate 2 to be formed.

The organic EL element 3 has a first electrode 31 with a terminal 31a, a second electrode 32 with a terminal 32a, and an organic layer 33 provided between the both electrodes 31, 32.

In the organic EL element 3, using the organic layer 33 as a basis, the terminal 31a of the first electrode 31 is provided on a first side and the terminal 32a of the second electrode 32 is provided on a second side. The first side and the second side are mutually opposite sides, and for example, the first side is one side in the short-side direction of the supporting substrate 2 and the second side is the other side in the short-side direction of the supporting substrate 2.

The belt-shaped sealing substrate 5 is laminated on and bonded to the surface of the supporting substrate 2 so as to cover the surface of the organic EL element 3 excluding these terminals 31a, 32a.

As illustrated in Fig. 2, a layer configuration of the organic EL device 1 is a laminated structure including the belt-shaped supporting substrate 2, the first electrode 31 provided on the belt-shaped supporting substrate 2, the organic layer 33 provided on the first electrode 31, the second electrode 32 provided on the organic layer 33, and the sealing substrate 5 provided on the second electrode 32.

When the supporting substrate 2 has electric conductivity, an insulating layer (not illustrated) is provided between the supporting substrate 2 and the first electrode 31 in order to prevent an electrical short-circuit.

For example, the organic EL element 3 is formed in a substantially rectangular planar shape. Of course, the planar shape of the organic EL element 3 is not limited to a substantially rectangular shape, and for example, may be formed in a substantially square shape, a circular shape, or the like.

The organic layer 33 of the organic EL element 3 includes a light emitting layer, and has various kinds of functional layers such as a positive hole transport layer and an electron transport layer, as necessary. The layer configuration of the organic layer 33 is described later.

For forming the terminal 31a of the first electrode 31, the organic layer 33 is provided on the surface of the first electrode 31, exclusive of the end portion (terminal 31a) of the first electrode 31 on the first side.

The second electrode 32 is provided on the surface of the organic layer 33 so as to cover a surface of the organic layer 33. For forming the terminal 32a of the second electrode 32, the end portion (terminal 32a) of the second electrode 32 is drawn from the end portion of the organic layer 33 to the second side.

The terminals 31a and 32a of the first electrode 31 and the second electrode 32 are portions that are connected to the outside. The terminal 31a of the first electrode 31 is an exposed surface of the first electrode 31, and the terminal 32a of the second electrode 32 is an exposed surface of the second electrode 32.

The sealing substrate 5 is bonded onto the surface of the organic EL element 3 (second electrode 32) via the adhesive layer 4 so as not to cover respective terminals 31a, 32a of the first electrode 31 and the second electrode 32. The adhesive layer 4 is a layer of which a thermosetting type adhesive agent is cured.

The sealing substrate 5 is a layer for preventing oxygen, water vapor and the like from entering the organic EL element 3.

The sealing substrate 5 airtightly covers the whole part of the organic EL element 3 excluding the respective terminals 31a, 32a. For details, the sealing substrate 5 is bonded onto the surface of the second electrode 32 excluding the respective terminals 31a, 32a, and furthermore, as illustrated in Fig. 2, the sealing substrate 5 is bonded to the peripheral end face of the organic EL element 3. Moreover, the peripheral edge parts of the sealing substrate 5 each are bonded to the surface of the supporting substrate 2, the surface of the first electrode 31 and the surface of the second electrode 32. The peripheral end face of the organic EL element 3 is a peripheral face configuring the thickness of the element 3.

As illustrated in Fig. 3, as necessary, a barrier layer 59 may be laminated on the rear face of the sealing substrate 5. The rear face of the sealing substrate 5 is a face opposite the organic EL element 3. Accordingly, the barrier layer 59 is interposed between the sealing substrate 5 and the second electrode 32. While a forming material for the barrier layer is not particularly limited, but examples include a metal oxide film, an oxynitride film, a nitride film, and a carbide nitride oxide film. Examples of the metal oxide include MgO, SiO, SiₓO_{y}, Al₂O₃, GeO, and TiO₂. The barrier layer 59 is preferably a silicon carbide nitride oxide film (SiOCN), a silicon oxynitride film (SiON), and a silicon nitride film (SiN). A thickness of the barrier layer 59 is not particularly limited, but it is 50 nm to 10 µm, for example.

Moreover, although the sealing substrate 5 is bonded to the peripheral end face of the organic EL element 3 in an example illustrated in Fig. 2, for example, as illustrated in Fig. 3, the sealing substrate 5 may be bonded so as not to cover the peripheral end face of the organic EL element 3 (in this case, the sealing substrate 5 is bonded only to a surface side of the organic EL element 3).

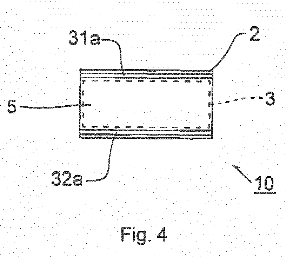

The belt-shaped organic EL device 1 is appropriately cut at the boundary part between adjacent organic EL elements 3 at the time of using. In Fig. 1, cutting portions are shown by arrows. By processing the belt-shaped organic EL device 1 as described above, a sheet-like organic EL device 10 illustrated in Fig. 4 is obtained.

The organic EL devices 1, 10 can be used alone or in combination of plural kinds thereof to be utilized as a light emitting panel for lighting equipment, an image display, or the like.

Hereinafter, the forming materials for the organic EL device, the production method, and the like will be described in detail.

### [Supporting substrate and sealing substrate]

Either of the belt-shaped supporting substrate and the belt-shaped sealing substrate is a flexible sheet-shaped object. Although the length (length in the long-side direction) of each of the belt-shaped supporting substrate and the sealing substrate is not particularly limited, for example, the length is 10 m to 1000 m. Moreover, although the width (length in the short-side direction) of the supporting substrate is not also particularly limited, for example, the width is 10 mm to 300 mm, preferably 10 mm to 100 mm. Since the organic EL device 1 illustrated in Fig. 1 allows the terminals 31a, 32a to be arranged at both sides in the short-side direction of the supporting substrate 2, the width of the sealing substrate 5 is slightly shorter than the width of the supporting substrate 2.

With regard to the supporting substrate and the sealing substrate, provided that both substrates are not opaque, one substrate may be transparent and the other substrate may be opaque, or both substrates may be transparent. In this connection, being transparent refers to being colorless transparent or being colored transparent. The index of transparency may be, for example, a total light transmittance of 70% or more, preferably 80% or more. It is to be noted that the total light transmittance is a value measured by a measurement method conforming to JIS K7105 (Method of Testing Optical Characteristics of Plastics). When a bottom emission type organic EL device is formed, a transparent supporting substrate is used. When a top emission type organic EL device is formed, a transparent sealing substrate is used.

In the present invention, for each of the supporting substrate and the sealing substrate, a substrate which is capable of preventing the entry of moisture, oxygen and the like and is excellent in gas and water vapor barrier properties is used. For example, each of the supporting substrate and the sealing substrate may be appropriately selected from a metal sheet, a resin sheet, a glass sheet, a ceramic sheet, and the like to be used. Herein, a sheet includes one generally called a film. As the supporting substrate and the sealing substrate, although any ones of sheets differing in material quality, sheets of the same kind and two identical sheets are acceptable, it is preferred that sheets differing in material quality from each other be used. For example, as the supporting substrate, a metal sheet or a glass sheet is used, and as the sealing substrate, a resin sheet is used.

Although the metal sheet is not particularly limited, examples thereof include flexible thin plates composed of stainless steel, copper, titanium, aluminum, an alloy, and the like. For example, a thickness of the metal sheet is 10 µm to 100 µm.

Although the resin sheet is not particularly limited, examples thereof include flexible synthetic resin sheets such as those of polyester-based resins such as polyethylene terephthalate (PET), polyethylene naphthalate (PEN), and polybutylene terephthalate (PBT); olefin-based resins having an α-olefin as a monomer component, such as polyethylene (PE), polypropylene (PP), polymethylpentene (PMP), ethylene-propylene copolymers, and ethylene-vinyl acetate copolymers (EVA); polyvinyl chloride (PVC); vinyl acetate-based resins; polycarbonate (PC); polyphenylene sulfide (PPS); amide-based resins such as polyamide (nylon) and wholly aromatic polyamide (aramid); polyimide-based resins; and polyether ether ketone (PEEK). A thickness of the resin sheet is not particularly limited, but it is 10 µm to 200 µm, for example. The above mentioned barrier layer may be laminated on at least one face of the resin sheet since good gas and water vapor barrier properties can be imparted.

For preventing a rise in temperature of the organic EL device at the time of driving, the supporting substrate and the sealing substrate are preferably excellent in heat dissipation. In the case where conductive substrates (metal sheets or the like) are used as the supporting substrate and the sealing substrate, in order to insulate the conductive substrate from an electrode opposite the conductive substrate, an insulating layer is provided on the front face of the supporting substrate or the rear face of the sealing substrate.

Preferably, as the supporting substrate and the sealing substrate, substrates differing in the coefficient of linear thermal expansion from each other are used. For example, as the supporting substrate, a substrate having a larger coefficient of linear thermal expansion than the sealing substrate is used (in this case, the sealing substrate is a substrate having a smaller coefficient of linear thermal expansion). Alternatively, as the supporting substrate, a substrate having a smaller coefficient of linear thermal expansion than the sealing substrate is used (in this case, the sealing substrate is a substrate having a larger coefficient of linear thermal expansion). As described above, the supporting substrate may have a larger or smaller coefficient of linear thermal expansion than the sealing substrate.

Although the difference between the coefficient of linear thermal expansion of the supporting substrate and the coefficient of linear thermal expansion of the sealing substrate is not particularly limited as long as the difference is greater than zero, when the difference is excessively small, a curling habit eliminating effect of the organic EL device based on the difference in the coefficient of linear thermal expansion is not sometimes sufficiently exerted. From the viewpoint, the difference is preferably greater than or equal to 0.1 ppm/°C, more preferably greater than or equal to 0.5 ppm/°C, and further preferably greater than or equal to 1 ppm/°C. Although substantially no adverse effect is exerted on the curling habit eliminating effect even when the difference is too large, in the case of using a general-purpose supporting substrate or a general-purpose sealing substrate, for example, the difference is less than or equal to 30 ppm/°C and preferably less than or equal to 20 ppm/°C.

The difference between the coefficient of linear thermal expansion of the supporting substrate and the coefficient of linear thermal expansion of the sealing substrate is an absolute value calculated from the subtraction between both coefficients of linear thermal expansion. That is, the difference is determined from the equation of the difference between the coefficient of linear thermal expansion of the supporting substrate and the coefficient of linear thermal expansion of the sealing substrate = | the coefficient of linear thermal expansion of the supporting substrate · the coefficient of linear thermal expansion of the sealing substrate|.

Moreover, the coefficient of linear thermal expansion refers to a value measured by a TMA method (a thermomechanical analysis method) in accordance with JIS K 7197.

For example, the coefficient of linear thermal expansion of a substrate having a larger coefficient of linear thermal expansion is 19 ppm/°C to 30 ppm/°C.

For example, the coefficient of linear thermal expansion of a substrate having a smaller coefficient of linear thermal expansion is 4 ppm/°C to 18 ppm/°C.

In general, although it can be said that the resin sheet has a larger coefficient of linear thermal expansion as compared with the metal sheet, the glass sheet, and the like, depending on the material quality thereof, there is also a case where the resin sheet has a smaller coefficient of linear thermal expansion as compared therewith. Consequently, the substrate having a larger coefficient of linear thermal expansion and the substrate having a smaller coefficient of linear thermal expansion are appropriately selected in view of the material quality thereof and the like.

In one preferred embodiment, as the supporting substrate having a smaller coefficient of linear thermal expansion, a metal sheet such as a stainless steel thin plate (a metal sheet on which an insulating layer is provided on the surface) is used, and as the sealing substrate having a larger coefficient of linear thermal expansion, a resin sheet such as a polyethylene terephthalate sheet (preferably, a resin sheet on which a barrier layer is laminated) is used.

In another preferred embodiment, as the supporting substrate having a larger coefficient of linear thermal expansion, a resin sheet such as a polyethylene terephthalate sheet (preferably, a resin sheet on which a barrier layer is laminated) is used, and as the sealing substrate having a smaller coefficient of linear thermal expansion, a metal sheet such as a stainless steel thin plate is used.

In order to impart the metal sheet and the resin sheet with desired functions, arbitrary layers may be laminated on those sheets respectively.

### [Organic EL Element having First Electrode, Organic Layer, and Second Electrode]

A first electrode is an anode, for example.

The formation material of the first electrode (anode) is not particularly limited, but examples include indium tin oxide (ITO); indium tin oxide including silicon oxide (ITSO); aluminum; gold; platinum; nickel; tungsten; copper; and an alloy. When a bottom emission type organic EL device is formed, a transparent first electrode is used.

A thickness of the first electrode is not particularly limited, but it is usually 0.01 µm to 1.0 µm.

An organic layer has a laminated structure composed of at least two layers. Examples of a structure of the organic layer include (A) a structure composed of three layers including a positive hole transport layer, a light emitting layer, and an electron transport layer; (B) a structure composed of two layers including a positive hole transport layer and a light emitting layer; and (C) a structure composed of two layers including a light emitting layer and an electron transport layer.

In the organic layer of the above-mentioned (B), the light emitting layer also works as an electron transport layer. In the organic layer of the above-mentioned (C), the light emitting layer works as a positive hole transport layer.

The organic layer used in the present invention can have any of the structures (A) to (C) mentioned above.

The organic layer having the structure (A) is explained below.

The positive hole transport layer is provided on the surface of the first electrode. An arbitrary function layer other than the first electrode and the positive hole transport layer may be interposed between the first electrode and the positive hole transport layer under the conditions in which the light emitting efficiency of the organic EL element is not lowered.

For example, the positive hole injection layer may be provided on the surface of the first electrode, and the positive hole transport layer may be provided on the surface of the positive hole injection layer. The positive hole injection layer is a layer having a function of aiding injection of a positive hole from the anode layer to the positive hole transport layer.

A formation material of the positive hole transport layer is not particularly limited as long as the formation material has a positive hole transport function. Examples of the formation material for the positive hole transport layer include an aromatic amine compound such as 4,4',4"-tris(carbazole-9-yl)-triphenyl amine (abbreviation: TcTa); a carbazole derivative such as 1,3-bis(N-carbazolyl) benzene; a spiro compound such as N,N'-bis(naphthalene-1-yl)-N,N'-bis(phenyl)-9,9'-spiro-bisfluorene (abbreviation: Spiro-NPB); a polymer compound; and the like. The formation material of the positive hole transport layer may be used singly or in combination of two or more formation materials. Furthermore, the positive hole transport layer may be a multi-layer structure having two or more layers.

A thickness of the positive hole transport layer is not particularly limited, but the thickness of 1 nm to 500 nm is preferable from the viewpoint of reducing drive voltage.

A light emitting layer is provided on the surface of the positive hole transport layer.

A formation material of the light emitting layer is not particularly limited as long as it has light emitting property. Examples of the formation material of the light emitting layer include a low molecular light emission material such as a low molecular fluorescence emission material, and a low molecular phosphorescence emission material.

Examples of the low molecular light emission material include an aromatic dimethylidene compound such as 4,4'-bis(2,2'-diphenyl vinyl)-biphenyl (abbreviation: DPVBi); an oxadiazole compound such as 5-methyl-2- [2- [4-(5-methyl-2-benzoxazolyl)phenyl]vinyl]benzoxazole; a triazole derivative such as 3-(4-biphenyl-yl)-4-phenyl-5-t-butyl phenyl-1,2,4-triazole; a styryl benzene compound such as 1,4-bis(2-methyl styryl)benzene; a benzoquinone derivative; a naphthoquinone derivative; an anthraquinone derivative; a fluorenone derivative; an organic metal complex such as an azomethine-zinc complex, tris(8-quinolinolato) aluminum (abbreviation: Alq₃), and the like.

Furthermore, as the formation material for the light emitting layer, a host material doped with light emitting dopant material may be used.

For the host material, for example, the above-mentioned low molecular light emission material can be used, and, other than this, a carbazole derivative such as 1,3,5-tris(carbazo-9-yl)benzene (abbreviation: TCP), 1,3-bis(N-carbazolyl)benzene (abbreviation: mCP), 2,6-bis(N-carbazolyl)pyridine, 9,9-di(4-dicarbazole-benzyl)fluorene (abbreviation: CPF), 4,4'-bis(carbazole-9-yl)-9,9-dimethyl-fluorene (abbreviation: DMFL-CBP), and the like can be used.

Examples of the dopant material include a styryl derivative; a perylene derivative; a phosphorescence emission metal complex including an organic iridium complex such as tris(2-phenyl pyridyl)iridium (III) (Ir(ppy)₃), tris(1-phenyl isoquinoline)iridium (III) (Ir(piq)₃), and bis(1-phenyl isoquinoline) (acetylacetonato) iridium (III) (abbreviation: Ir(piq)₂(acac)), and the like.

Furthermore, the formation material of the light emitting layer may include such as the formation material for the positive hole transport layer mentioned above, the formation material of the electron transport layer mentioned below, and various additives.

A thickness of the light emitting layer is not particularly limited, but the thickness of 2 nm to 500 nm is preferable, for example.

The electron transport layer is provided on the surface of the light emitting layer. An arbitrary function layer other than the second electrode and the electron transport layer may be interposed between the second electrode and the electron transport layer under the conditions in which the light emitting efficiency of the organic EL element is not lowered.

For example, the electron injection layer may be provided on the surface of the electron transport layer, and the second electrode may be provided on the surface of the electron injection layer. The electron injection layer is a layer having a function of aiding injection of an electron from the second electrode to the electron transport layer.

A formation material of the electron transport layer is not particularly limited as long as it is a material having an electron transport function. Examples of the formation material of the electron transport layer include a metal complex such as tris(8-quinolinolato) aluminum (abbreviation: Alq₃), bis(2-methyl-8-quinolinolato)(4-phenyl phenolate) aluminum (abbreviation: BAlq); a heteroaromatic compound such as 2,7-bis[2-(2,2'-bipyridine-6-yl)-1,3,4-oxadiazo-5-yl]-9,9-dimethyl fluorene (abbreviation: Bpy-FOXD), 2-(4-biphenylyl)-5-(4-tert-butyl phenyl)-1,3,4-oxadiazole (abbreviation: PBD), 1,3-bis[5-(p-tert-butyl phenyl)-1,3,4-oxadiazole-2-yl]benzene (abbreviation: OXD-7), and 2,2',2"-(1,3,5-phenylene)-tris(1-phenyl-1H-benzimidazole) (abbreviation: TPBi); and a polymer compound such as poly(2,5-pyridine-diyl) (abbreviation: PPy). The formation material of the electron transport layer may be used singly or in combination of two or more types. Furthermore, the electron transport layer may have a multi-layered structure composed of two or more layers.

A thickness of the electron transport layer is not particularly limited, but the thickness of 1 nm to 500 nm is preferable from the viewpoint of reducing drive voltage.

A second electrode is a cathode, for example.

A formation material of the second electrode is not particularly limited, but a transparent second electrode is used when a top emission type organic EL element is formed. Examples of the formation material of the second electrode which is transparent and has electric conductivity include indium tin oxide (ITO); indium tin oxide including silicon oxide (ITSO); zinc oxide in which electric conductive metal such as aluminum is added (ZnO : Al); and a magnesium-silver alloy, and the like. A thickness of the second electrode is not particularly limited, but it is usually 0.01 µm to 1.0 µm.

### [Method for producing organic EL device]

The method for producing an organic EL device according to the present invention includes the laminating step of laminating a belt-shaped sealing substrate on a belt-shaped supporting substrate on which a plurality of organic EL elements is formed while interposing an uncured thermosetting type adhesive layer so as to cover the organic EL elements, the winding step of winding a belt-shaped laminated body having the belt-shaped supporting substrate, the organic EL elements and the sealing substrate into a roll, and the curing step of applying heat to the laminated body to perform curing of the adhesive layer while the laminated body remains wound into a roll.

Preferably, before the laminating step, the production method includes the feed-out step of feeding out a flexible belt-shaped supporting substrate and the element-forming step of forming a plurality of organic EL elements on the belt-shaped supporting substrate.

It is preferred that the feed-out step, the element-forming step, the laminating step and the winding step be performed by a roll-to-roll method.

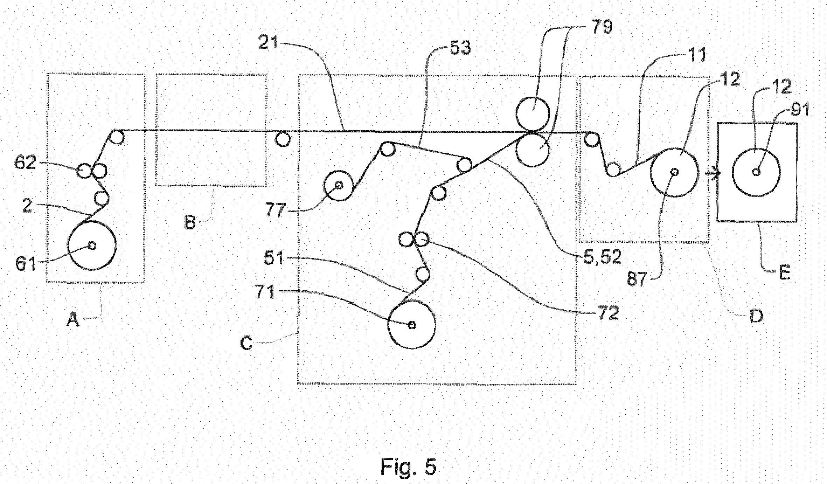

Fig. 5 is a schematic view of a production apparatus of an organic EL device in accordance with one embodiment. In Fig. 5, a part surrounded by a dotted line denoted by the reference character A is the feed-out section for a belt-shaped supporting substrate, a part denoted by the reference character B is the element-forming section, a part denoted by the reference character C is the laminating section, and a part denoted by the reference character D is the winding section for a belt-shaped organic EL device. A part denoted by the reference character E is the curing section for a thermosetting type adhesive layer.

### (Feed-out step)

As illustrated in Fig. 5, a belt-shaped supporting substrate 2 is wound into a roll.

The feed-out section A is provided with transport means for the supporting substrate 2. The transport means for the supporting substrate 2 has a core roller 61 around which the supporting substrate 2 is wound, and a nip roller 62 with which the supporting substrate 2 is fed out from the core roller 61. The nip roller 62 is provided with a motor (not illustrated) which rotates the roller.

In the present embodiment, it is preferred that a substrate having a smaller coefficient of linear thermal expansion be used as the supporting substrate 2.

### (Element-forming step)

The forming step of an organic EL element is performed in the same manner as that for a conventional one.

In the element-forming section B in Fig. 5, devices (for example, a deposition device) for forming an organic EL element are not illustrated.

In a brief description, the supporting substrate 2 fed out is washed in a washing tub, as necessary, and then dried. After being washed and dried, a first electrode is formed on the surface of the supporting substrate 2.

As the formation method of the first electrode, an optimum method can be employed depending on the formation material, and examples of the method include a sputtering method, a vapor deposition method, an ink-jet method, and the like. For example, when the anode is formed of metal, the vapor deposition method is used. A supporting substrate 2 with a first electrode patterned beforehand may be used. When the supporting substrate 2 with a first electrode patterned beforehand is used, the substrate is unwound from the roll, and washed and dried.

An organic layer is formed on the surface of the first electrode, exclusive of a terminal thereof. On the surface of the first electrode, a positive hole transport layer, a light emitting layer, and an electron transport layer can be formed in this order to form an organic layer, for example. As the formation method of the positive hole transport layer and the electron transport layer, an optimum method can be employed depending on the formation material, and examples of the method include a sputtering method, a vapor deposition method, an ink-jet method, a coating method, and the like. As the formation method of the light emitting layer, an optimum method can be employed depending on the formation material, but usually it is formed by a vapor deposition method.

Subsequently, the second electrode is formed on the organic layer. The second electrode is formed so as not to cover the terminal of the first electrode. As the formation method of the second electrode, an optimum method can be employed depending on the formation material, and examples of the method include a sputtering method, a vapor deposition method, an ink-jet method, and the like.

In this way, a plurality of organic EL elements is formed at necessary intervals on the belt-shaped supporting substrate 2 in the long-side direction. A barrier layer may be provided on the surface of the second electrode as necessary.

The intervals between the organic EL elements are not particularly limited, and it is appropriately set. For example, the intervals may be 0.5 mm to 5 mm.

### (Laminating step)

The laminating step is the step of sticking the belt-shaped sealing substrate 5 onto the belt-shaped supporting substrate 2 on which the organic EL elements have been formed. In the present embodiment, it is preferred that a substrate having a larger coefficient of linear thermal expansion be used as the sealing substrate 5.

The supporting substrate on which the organic EL elements are formed (hereinafter, referred to as an element-formed supporting substrate 21) is introduced to the laminating section C.

The laminating section C is provided with transport means for the sealing substrate 5, and nip rollers for lamination 79, 79 with which the sealing substrate 5 is stuck and pressed onto the element-formed supporting substrate 21. On the rear face of the sealing substrate 5 before introduced to the nip rollers for lamination 79, 79, an uncured thermosetting type adhesive layer is provided to bond on the element-formed supporting substrate 21.

In the present embodiment, a sealing substrate with a separator 51 in which the uncured thermosetting type adhesive layer is previously coated on the rear face of the sealing substrate and the uncured thermosetting type adhesive layer is temporarily stuck to a separator is used.

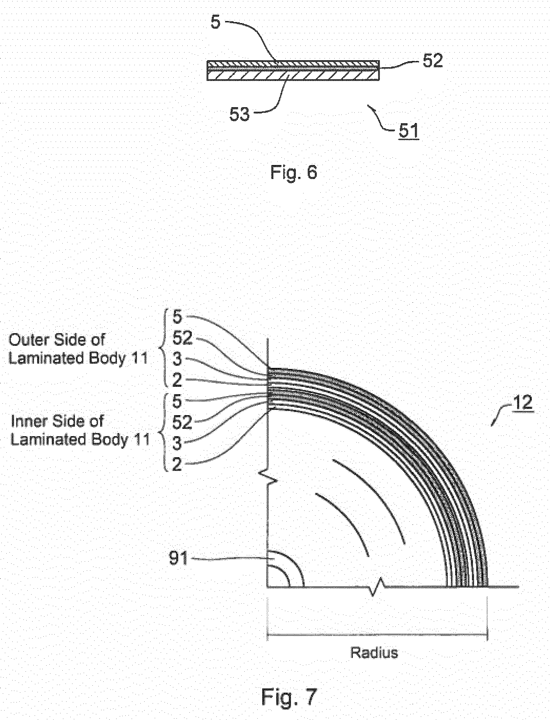

Fig. 6 is a sectional view of the sealing substrate with a separator 51. In Fig. 6, on the rear face of the sealing substrate 5, the uncured thermosetting type adhesive layer 52 is coated. On the sealing substrate 5, a barrier layer may be laminated (not illustrated in Fig. 6). By temporarily sticking the uncured thermosetting type adhesive layer 52 to a belt-shaped separator 53, the separator 53, the thermosetting type adhesive layer 52 and the sealing substrate 5 are laminated to constitute the sealing substrate with a separator 51. As the separator 53, a belt-shaped sheet-shaped object with a surface subjected to a release treatment is used so as to be easily peeled off from the uncured thermosetting type adhesive layer 52.

A thermosetting type adhesive agent constituting the thermosetting type adhesive layer 52 is not particularly limited, and examples include adhesive agents composed mainly of an epoxy resin, a phenol resin, a polyurethane resin, a melamine resin, and the like.

A thickness of the uncured thermosetting type adhesive layer 52 is not limited, but it is 5 µm to 50 µm, for example.

The transport means for the sealing substrate 5 has a core roller 71 around which the sealing substrate with a separator 51 is wound, a nip roller 72 with which the sealing substrate with a separator 51 is fed out from the core roller 71, and a recovery roller 77 by which only the separator 53 is recovered from the sealing substrate with a separator 51. The nip roller 72 and the recovery roller 77 are respectively provided with a motor (not illustrated) which rotates the respective rollers.

With the nip roller 72, the sealing substrate with a separator 51 is transported synchronizedly with the transport of the element-formed supporting substrate 21, and on the way, only the separator 53 is peeled off from the thermosetting type adhesive layer 52 to be wound around the recovery roller 77. On the rear face of the sealing substrate 5 from which the separator 53 is peeled off, the uncured thermosetting type adhesive layer 52 has been stuck. The sealing substrate 5 is introduced to a gap between the nip rollers for lamination 79, 79 so that the thermosetting type adhesive layer 52 faces the element-formed supporting substrate 21 side.

By introducing the element-formed supporting substrate 21 and the sealing substrate 5 which are transported to a gap between the nip rollers for lamination 79, 79, the rear face of the sealing substrate 5 is stuck to the element-formed supporting substrate 21 via the uncured adhesive layer 52.

In this way, it is possible to obtain a belt-shaped laminated body 11 having a supporting substrate, organic EL elements, an uncured thermosetting type adhesive layer and a sealing substrate in this order.

### (Winding step)

The laminated body 11 is wound into a roll.

The winding length of the laminated body 11 is not particularly limited. For example, the laminated body 11 is wound into a roll with a diameter greater than or equal to 100 mm, and wound into a roll with a diameter preferably greater than or equal to 200 mm and more preferably greater than or equal to 300 mm.

Although there is no upper limit for the winding length of the laminated body 11, since the handling of the roll-shaped laminated body (the wound body) becomes complicated when the laminated body is excessively large, actually, it is preferred that the diameter be less than or equal to 500 mm.

The winding section D is provided with winding means for the laminated body 11. The winding means has a core roller 87 around which the belt-shaped laminated body 11 is wound, and a motor (not illustrated) which rotates the core roller 87.

Fig. 7 is a reference sectional view schematically showing a part of a wound body 12 prepared by winding the laminated body 11 around a winding core 91. For example, the diameter of the wound body 12 is greater than or equal to 100 mm, as described above.

In Fig. 7, the laminated body 11 has the belt-shaped supporting substrate 2, the organic EL elements 3, the uncured thermosetting type adhesive layer 52, and the sealing substrate 5. In the present embodiment, the laminated body 11 is wound around the winding core 91 so that the sealing substrate 5 faces outward. In the wound body 12, the supporting substrate 2 in the outer laminated body 11 is overlapped with the sealing substrate 5 in the inner laminated body 11, and sequentially, the respective wound laminated bodies 11 are overlapped. Accordingly, the sealing substrate 5 in each of the wound laminated bodies 11 is positioned at an outer side than the supporting substrate 2. Moreover, the thermosetting type adhesive layer 52 in the wound laminated body 11 remains uncured (that is, in a state of not being cured completely).

### (Curing step for adhesive layer)

As described above, the laminated body 11 wound so that the sealing substrate 5 faces outward is moved to the curing section E while the laminated body remains wound into a roll, and the uncured thermosetting type adhesive layer 52 is cured.

The curing section E is provided with a heating device (not illustrated). The heating device is not particularly limited, and examples thereof include an oven, an IR heating device, a high frequency induction heating device, a high frequency dielectric heating device, a hot plate, and the like. The heating conditions such as the temperature of the heating device and the heating time are appropriately set according to the kind of the adhesive agent so that the thermosetting type adhesive agent is cured.

By curing the thermosetting type adhesive layer 52, the sealing substrate 5 is bonded and fixed to the organic EL elements 3 and the supporting substrate 2 via the adhesive layer 4 after curing. In this way, it is possible to obtain the belt-shaped organic EL device illustrated in Fig. 1.

According to the present invention, the curing step for the uncured thermosetting type adhesive layer is performed while the laminated body is not transported and remains wound into a roll. In a roll-to-roll method, in order to transport the laminated body, and on the way, to perform the curing of the adhesive layer, a very large heating device is required. In this point, according to the present invention, since the curing treatment of the thermosetting type adhesive layer is performed separately at a place other than the production line of a roll-to-roll method, the thermosetting type adhesive layer can be cured using a relatively small heating device, and furthermore, the transport speed of the roll-to-roll production line can also be increased for enhancing the productivity. Moreover, by performing a heating treatment while the laminated body remains wound into a roll, it is possible to perform curing of a larger amount of the adhesive layer during the heating treatment performed one time. Consequently, the production method is also excellent in production efficiency.

Moreover, the production method of the present invention is one in which a laminated body (a wound body) remaining wound while a sealing substrate (a substrate having a larger coefficient of linear thermal expansion) facing outward is heated. With regard to a belt-shaped organic EL device obtained by the production method, the organic EL device is not curved and becomes substantially flat at the time of being fed out from a winding core.

For details, when a laminated body is heated to produce a belt-shaped organic EL device while the laminated body remains wound into a roll, a curling habit is formed in the organic EL device. Consequently, when the obtained belt-shaped organic EL device is fed out from a winding core, due to the curling habit, the organic EL device is curved. In this point, in the present invention, a laminated body is wound so that a sealing substrate (a substrate having a larger coefficient of linear thermal expansion) faces outward and a supporting substrate (a substrate having a smaller coefficient of linear thermal expansion) faces inward. At the time of heating this roll-shaped laminated body, while the sealing substrate is expanded more greatly than the supporting substrate, the thermosetting type adhesive layer is thermally cured. By the curing of the thermosetting type adhesive layer, an organic EL device in which the sealing substrate in a state of being stretched more greatly than the supporting substrate in the long-side direction is fixed is obtained. After the heating, when the supporting substrate and the sealing substrate are allowed to cool, although shrinkage stresses are generated inside both substrates which have been expanded, the sealing substrate has a larger shrinkage stress. Although the sealing substrate which has been expanded does not shrink practically in a state of being wound around a winding core, at the time of feeding out the organic EL device from the winding core, the sealing substrate shrinks more greatly than the supporting substrate. Since the sealing substrate positioned at an outer side shrinks more greatly than the supporting substrate positioned at an inner side and the curling habit are mutually cancelled, the organic EL device fed out from the winding core becomes substantially flat.

Since the organic EL device thus obtained by the production method of the present invention is hardly curved, the sealing substrate hardly peels off from the organic EL element, and moreover, the organic EL element is hardly damaged. Consequently, according to the present invention, it is possible to provide an organic EL device which is excellent in durability and capable of stably emitting light for a relatively long period of time. In particular, by heating the laminated body in a state of being wound into a roll with a diameter greater than or equal to 100 mm, the effects described above are significantly exerted.

### [Another embodiment of method for producing organic EL device]

The production method of the present invention is not limited to the foregoing embodiment, and the design can be variously changed within the scope intended by the present invention.

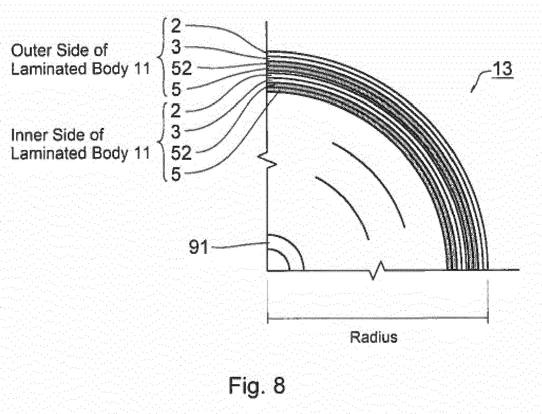

For example, in the production method in accordance with the foregoing embodiment, although the laminated body 11 is wound into a roll so that the sealing substrate 5 faces outward, the procedure is not limited thereto, and as illustrated in Fig. 8, the laminated body 11 may be wound into a roll so that the supporting substrate 2 faces outward. The wound body 13 allowing the supporting substrate 2 to face outward is heated in the curing step in the same manner as that in the foregoing embodiment to perform curing of the thermosetting type adhesive layer. In this case, by using a substrate having a larger coefficient of linear thermal expansion as the supporting substrate 2 and a substrate having a smaller coefficient of linear thermal expansion as the sealing substrate 5, based on the principle described in the foregoing embodiment, it is possible to obtain an organic EL device which becomes substantially flat at the time of being fed out from the winding core 91.

Moreover, in the production method in accordance with the foregoing embodiment, although the laminating step is performed subsequently to the element-forming step (that is, although the element-formed supporting substrate 21 is not wound, the element-formed supporting substrate is transported in the same production line, and the sealing substrate 5 is stuck thereto), the procedure is not limited thereto. For example, the element-formed supporting substrate 21 is once wound, after which the supporting substrate 2 may be fed out again to perform the laminating step.

Furthermore, in the production method of the foregoing embodiment, although the sealing substrate with a separator 51 is used, a sealing substrate 5 may be used without being temporarily stuck to the separator 53. In this case, when an uncured thermosetting type adhesive layer 52 is previously coated on the sealing substrate 5, the sealing substrate 5 wound into a roll causes blocking. Consequently, it is preferred that only a sealing substrate 5 be wound into a roll and an uncured adhesive agent be coated on the rear face of the sealing substrate 5 just before the sealing substrate 5 is introduced to the nip roller for lamination 79.

Moreover, in the production method in accordance with the foregoing embodiment, although the winding step and the curing step for the adhesive layer are separately performed (that is, although the laminated body is wound at the winding section D and then moved to the curing section E to cure the adhesive layer), the procedure is not limited thereto.

For example, the winding step and the curing step may be performed by means of one device. Specifically, a heating device is provided with the winding section. The laminated body 11 is wound around a core roller 87 in the winding section so that the sealing substrate 5 faces outward, after which the roll-shaped laminated body 11 may be directly heated by means of the heating device.

### EXAMPLES

Hereinafter, the present invention will be described in more detail with reference to examples and comparative examples. However, the present invention should not be limited to the following examples.

### [Substrate used]

### (A) Metal sheet-containing substrate

As a metal sheet-containing substrate, one prepared by laminating an insulating layer with a thickness of 3 µm on a sheet of SUS304 foil (available from TOYO SEIHAKU CO., LTD.) with a thickness of 50 µm was used. Using an acrylic resin (available from JSR Corporation, trade name "JEM-477"), the resin was coated on one face of the sheet of the stainless steel foil to form the insulating layer. The coefficient of linear thermal expansion of this metal sheet-containing substrate is 17 ppm/°C.

### (B) Metal sheet substrate

As a metal sheet substrate, a sheet of SUS304 foil (available from TOYO SEIHAKU CO., LTD.) with a thickness of 50 µm was directly used. The coefficient of linear thermal expansion of this metal sheet substrate is 17 ppm/°C.

### (C) Resin sheet-containing substrate

As a resin sheet-containing substrate, one prepared by laminating a SiO₂ layer (a barrier layer) with a thickness of 0.3 µm on one face of a polyethylene naphthalate film (available from Mitsubishi Plastics, Inc.) with a thickness of 50 µm by a sputtering method was used. The coefficient of linear thermal expansion of this resin-sheet containing substrate is 23 ppm/°C. In the case where this resin sheet-containing substrate is used as a sealing substrate, as described below, an adhesive layer was provided on the barrier layer.

The coefficient of linear thermal expansion of each of the substrates was measured by a TMA method (a thermomechanical analysis method) in accordance with JIS K 7197.

### [Example 1]

In Example 1, as a supporting substrate, the above-mentioned metal sheet-containing substrate was used, and as a sealing substrate, the above-mentioned resin sheet-containing substrate was used. The coefficient of linear thermal expansion of the metal sheet-containing substrate is smaller than that of the resin sheet-containing substrate. Accordingly, in Example 1, the supporting substrate is a substrate having smaller coefficient of linear thermal expansion, and the sealing substrate is a substrate having larger coefficient of linear thermal expansion.

In this way, an organic EL device was prepared using a production device illustrated in Fig. 5.

### (Element-forming step)

A belt-shaped metal sheet-containing substrate (40 mm in width, 100 m in length) wound into a roll was fed out and introduced to the element forming section B. On an insulating layer of the metal sheet-containing substrate, an Al layer with a thickness of 100 nm as a first electrode, and among organic layers, an HAT-CN (1,4,5,8,9,12-hexaazatriphenylene hexacarbonitrile) layer with a thickness of 10 nm as a hole injection layer, an NPB layer with a thickness of 50 nm as a hole transport layer, an Alq₃ layer with a thickness of 45 nm as a light-emitting layer and an electron transport layer, and an LiF layer with a thickness of 0.5 nm as an electron injection layer were heated and vapor deposited in this order, after which an Mg/Ag layer with thicknesses of 5/15 nm as a second electrode was co-vapor deposited, and furthermore, an ITO layer with a thickness of 50 nm was deposited by a sputtering method to form a plurality of the organic EL elements on the metal sheet-containing substrate. In this way, the element-formed supporting substrate was prepared.

### (Laminating Step)

As a sealing substrate, a belt-shaped resin sheet-containing substrate (35 mm in width, 100 m in length) in which an uncured epoxy-based thermosetting type adhesive agent layer (an uncured adhesive layer) with a thickness of 10 µm is provided on a barrier layer and a separator is provided on the adhesive agent layer was used.

The element-formed supporting substrate was introduced to the laminating section C and transported to a gap between the nip rollers for lamination 79, 79. On the other hand, the sealing substrate was fed out from the roller 71, and while peeling off the separator on the way, a sealing substrate having an uncured adhesive layer was transported to a gap between the nip rollers for lamination 79, 79. In the gap between the nip rollers 79, 79, the sealing substrate was stuck to the element-formed supporting substrate via the uncured adhesive layer to obtain a belt-shaped laminated body.

### (Winding step)

At the winding section D, the laminated body was wound into a roll with a diameter of 200 mm so that the sealing substrate faces outward. In this way, the belt-shaped laminated body was wound into a roll to obtain a wound body (see Fig. 7).

### (Curing step)

This wound body was moved to the curing section E (an oven with a nitrogen atmosphere was used) while the laminated body remained wound into a roll, and the adhesive layer was cured by heating the wound body at 80°C for 2 hours.

In this way, a belt-shaped top emission type organic EL device was prepared.

### [Examples 2 and 3, and Comparative Example 1]

An organic EL device was prepared in the same manner as that in Example 1 except that the diameter of the wound body was changed to a length listed in Table 1.

### [Comparative Examples 2 to 5]

An organic EL device was prepared in the same manner as that in Example 1 except that the laminated body was wound so that the supporting substrate faces outward at the time of winding the laminated body, and the diameter of the wound body was changed to a length listed in Table 1.

**[Table 1]**

| | Supporting Substrate | Sealing Substrate | Outer Side of Wound Roll | Diameter (mm) | Luminance Half-Life (hr) |
|---|---|---|---|---|---|
| Example 1 | Metal sheet-containing substrate | Resin sheet-containing substrate | Sealing substrate | 200 | 100 |
| Example 2 | Metal sheet-containing substrate | Resin sheet-containing substrate | Sealing substrate | 160 | 100 |
| Example 3 | Metal sheet-containing substrate | Resin sheet-containing substrate | Sealing substrate | 120 | 90 |
| Comparative Example 1 | Metal sheet-containing substrate | Resin sheet-containing substrate | Sealing substrate | 80 | 65 |
| Comparative Example 2 | Metal sheet-containing substrate | Resin sheet-containing substrate | Supporting substrate | 200 | 65 |
| Comparative Example 3 | Metal sheet-containing substrate | Resin sheet-containing substrate | Supporting substrate | 160 | 60 |
| Comparative Example 4 | Metal sheet-containing substrate | Resin sheet-containing substrate | Supporting substrate | 120 | 60 |
| Comparative Example 5 | Metal sheet-containing substrate | Resin sheet-containing substrate | Supporting substrate | 80 | 50 |

### [Example 4]

In Example 4, as a supporting substrate, the above-mentioned resin sheet-containing substrate was used, and as a sealing substrate, the above-mentioned metal sheet substrate was used. The coefficient of linear thermal expansion of the metal sheet substrate is smaller than that of the resin sheet-containing substrate. Accordingly, in Example 4, the supporting substrate is a substrate having a larger coefficient of linear thermal expansion, and the sealing substrate is a substrate having a smaller coefficient of linear thermal expansion.

A production device illustrated in Fig. 5 was used to prepare an organic EL device.

### (Element-forming step)

A belt-shaped resin sheet-containing substrate (40 mm in width, 100 m in length) wound into a roll was fed out and introduced to the element forming section B. On a barrier layer of the resin sheet-containing substrate, an ITO with a thickness of 100 nm was formed as a first electrode by a sputtering method. On this first electrode, among organic layers, an HAT-CN (1,4,5,8,9,12-hexaazatriphenylene hexacarbonitrile) layer with a thickness of 10 nm as a hole injection layer, an NPB layer with a thickness of 50 nm as a hole transport layer, an Alq₃ layer with a thickness of 45 nm as a light-emitting layer and an electron transport layer, an LiF layer with a thickness of 0.5 nm as an electron injection layer, and an Al layer with a thickness of 100 nm as a second electrode were heated and vapor deposited in this order to form a plurality of the organic EL elements on the resin sheet-containing substrate. In this way, the element-formed supporting substrate was prepared.

### (Laminating Step)

As a sealing substrate, a belt-shaped metal sheet-containing substrate (35 mm in width, 100 m in length) in which an uncured epoxy-based thermosetting type adhesive agent layer (an uncured adhesive layer) with a thickness of 10 µm is provided and a separator is provided on the adhesive agent layer was used.

The element-formed supporting substrate was introduced to the laminating section C and transported to a gap between the nip rollers for lamination 79, 79. On the other hand, the sealing substrate was fed out from the roller 71, and while peeling off the separator on the way, a sealing substrate having an uncured adhesive layer was transported to a gap between the nip rollers for lamination 79, 79. In the gap between the nip rollers 79, 79, the sealing substrate was stuck to the element-formed supporting substrate via the uncured adhesive layer to obtain a belt-shaped laminated body.

### (Winding step)

At the winding section D, the laminated body was wound into a roll with a diameter of 200 mm so that the supporting substrate faces outward. In this way, the belt-shaped laminated body was wound into a roll to obtain a wound body (see Fig. 8).

### (Curing step)

This wound body was moved to the curing section E (an oven with a nitrogen atmosphere was used) while the laminated body remained wound into a roll, and the adhesive layer was cured by heating the wound body at 80°C for 2 hours.

In this way, a belt-shaped bottom emission type organic EL device was prepared.

### [Examples 5 and 6, and Comparative Example 6]

An organic EL device was prepared in the same manner as that in Example 4 except that the diameter of the wound body was changed to a length listed in Table 2.

### [Comparative Examples 7 to 10]

An organic EL device was prepared in the same manner as that in Example 4 except that the laminated body was wound so that the supporting substrate faces outward at the time of winding the laminated body, and the diameter of the wound body was changed to a length listed in Table 2.

**[Table 2]**

| | Supporting Substrate | Sealing Substrate | Outer Side of Wound Roll | Diameter (mm) | Luminance Half-Life (hr) |
|---|---|---|---|---|---|
| Example 4 | Resin sheet-containing substrate | Metal sheet substrate | Supporting substrate | 200 | 100 |
| Example 5 | Resin sheet-containing substrate | Metal sheet substrate | Supporting substrate | 160 | 95 |
| Example 6 | Resin sheet-containing substrate | Metal sheet substrate | Supporting substrate | 120 | 85 |
| Comparative Example 6 | Resin sheet-containing substrate | Metal sheet substrate | Supporting substrate | 80 | 60 |
| Comparative Example 7 | Resin sheet-containing substrate | Metal sheet substrate | Sealing substrate | 200 | 60 |
| Comparative Example 8 | Resin sheet-containing substrate | Metal sheet substrate | Sealing substrate | 160 | 50 |
| Comparative Example 9 | Resin sheet-containing substrate | Metal sheet substrate | Sealing substrate | 120 | 40 |
| Comparative Example 10 | Resin sheet-containing substrate | Metal sheet substrate | Sealing substrate | 80 | 35 |

### [Evaluation of organic EL panel]

Each of the belt-shaped organic EL devices obtained in Examples and Comparative Examples above was cut at the boundary part between adjacent organic EL elements under an air atmosphere to obtain an organic EL panel (100 mm in length, 40 mm in width). The organic EL panels obtained in respective examples and respective comparative examples were measured for the luminance half-life described below. The results thereof are shown in respective tables.

### [Measurement of luminance half-life]

With regard to the luminance half-life, a voltage to be applied to each of the organic EL panels was determined so that the initial luminance becomes 1000 cd/m², and at the current value, the time required for the luminance of the panel to fall to half its initial value was measured. The value of the luminance half-life of a top emission type organic EL panel of each of Examples 2 and 3 and Comparative Examples 1 to 5 was a relative value obtained when the luminance half-life of the organic EL panel in Example 1 was defined as 100. Moreover, the value of the luminance half-life of a bottom emission type organic EL panel of each of Examples 5 and 6 and Comparative Examples 6 to 10 was a relative value obtained when the luminance half-life of the organic EL panel in Example 4 was defined as 100.

It is found that the organic EL devices of Examples 1 to 6 have a long luminance half-life as compared with respective comparative examples. It is presumed that this is because the organic EL devices of Examples 1 to 6 are hardly curved, and as a result, the sealing substrate is hardly separated from the organic EL element, and moreover, the organic EL element is hardly damaged.

Because of the contrast between Examples and Comparative Examples, it is found that such an organic EL device excellent in durability is obtained by winding the laminated body so that the substrate having a larger coefficient of linear thermal expansion faces outward and setting the winding diameter to a diameter greater than or equal to almost 100 mm.

### INDUSTRIAL APPLICABILITY

An organic EL device of the present invention can be used for illuminating devices, image displays, or the like, for example.

1, 10 Organic EL device, 11 Laminated body, 12, 13 Wound body, 2 Supporting substrate, 3 Organic EL element, 4 Adhesive layer, 5 Sealing substrate, 52 Uncured thermosetting type adhesive layer, 59 Barrier layer

## Claims

1. A method for producing an organic electroluminescence device, comprising:
a laminating step of laminating a belt-shaped sealing substrate on a belt-shaped supporting substrate on which a plurality of organic electroluminescence elements are formed while interposing an uncured thermosetting type adhesive layer;
a winding step of winding a belt-shaped laminated body having the belt-shaped supporting substrate, the organic electroluminescence elements and the sealing substrate into a roll; and
a curing step of applying heat to the laminated body to perform curing of the adhesive layer while the laminated body remains wound into a roll.

2. The method for producing an organic electroluminescence device according to claim 1, wherein either one substrate of the supporting substrate and the sealing substrate has a coefficient of linear thermal expansion larger than that of the other substrate, and
in the winding step, the laminated body is wound into a roll so that the one substrate having a larger coefficient of linear thermal expansion faces outward.

3. The method for producing an organic electroluminescence device according to claim 2, wherein the laminated body is wound into a roll with a diameter greater than or equal to 100 mm.

4. The method for producing an organic electroluminescence device according to claim 2 or 3, wherein the one substrate having a larger coefficient of linear thermal expansion is the sealing substrate, and
the supporting substrate has a coefficient of linear thermal expansion smaller than that of the sealing substrate.

5. The method for producing an organic electroluminescence device according to claim 2 or 3, wherein the one substrate having a larger coefficient of linear thermal expansion is the supporting substrate, and
the sealing substrate has a coefficient of linear thermal expansion smaller than that of the supporting substrate.
